# EUROPÄISCHE PATENTSCHRIFT

(11) **EP 1 943 721 B1**
(45) Veröffentlichungstag und Bekanntmachung des Hinweises auf die Patenterteilung: **17.07.2019**
(21) Anmeldenummer: 06819079.2
(22) Anmeldetag: 16.10.2006
(51) Int. Cl.: H05K 7/20, H02M 7/00

(54) **ELEKTRISCHE VORRICHTUNG, INSBESONDERE ZUR ANSTEUERUNG EINER MOTORISCH UND/ODER GENERATORISCH BETREIBBAREN ELEKTRISCHEN MASCHINE**
ELECTRICAL DEVICE, PARTICULARLY FOR DRIVING A MOTOR- AND/OR GENERATOR-OPERABLE ELECTRICAL MACHINE
DISPOSITIF ELECTRIQUE, EN PARTICULIER POUR LA COMMANDE D'UNE MACHINE ELECTRIQUE FONCTIONNANT EN MOTEUR ET/OU EN GENERATEUR

(30) Priorität: 14.10.2005 DE 102005050028
(43) Veröffentlichungstag der Anmeldung: 16.07.2008
(73) Patentinhaber: ROBERT BOSCH GMBH, 70442 Stuttgart (DE)
(72) Erfinder: JERG, Juergen, 72131 Ofterdingen (DE); ILIC, Erich, 72805 Unterhausen (DE); SAUR, Dietmar, 72810 Gomaringen (DE); KIENLE, Wolfram, 71106 Magstadt (DE)
(86) Internationale Anmeldenummer: PCT/EP2006/067422
(87) Internationale Veröffentlichungsnummer: WO 2007/042576

(56) Entgegenhaltungen:
- EP-A- 0 597 144
- WO-A-2004/008618
- WO-A-2004/057746
- FR-A- 2 855 652
- CORREVON M ET AL: "Power modules with IMS substrates for automotive applications" VTC SPRING 2002. IEEE 55TH. VEHICULAR TECHNOLOGY CONFERENCE. PROCEEDINGS. BIRMINGHAM, AL, MAY 6 - 9, 2002, IEEE VEHICULAR TECHNOLGY CONFERENCE, NEW YORK, NY : IEEE, US, Bd. VOL. 1 OF 4. CONF. 55, 6. Mai 2002 (2002-05-06), Seiten 2056-2062, XP010622179 ISBN: 0-7803-7484-3

## Beschreibung

### Stand der Technik

Aus der US 2004/0062005 A1 ist ein Leistungskonverter bekannt, der dazu dient, elektrische Industriemotoren anzusteuern. Diese Vorrichtung weist Schaltungseinheiten auf, die auf einem Kühlkörper angeordnet sind. Neben den Schaltungseinheiten sind elektrische Leiter angeordnet. Bei dieser Ausführung ist nachteilig, dass die elektrischen Leiter verhältnismäßig viel Bauraum beanspruchen.

Aus der WO 2004/057746 A1 ist ein Umrichtermodul bekannt, welches in einer übereinander angeordneten Ausführung Stromschaltmittel , eine Kühlvorrichtung und leistungsführende sowie signalführende Leiterebenen aufweist. Letztere sind als Vormontagemodul ausgeführt, wobei die Leiterebenen mittels Einpresselemente zusammengehalten werden. Die Einpresselemente sind aus einem isolierenden Material vorgesehen.

### Vorteile der Erfindung

Die erfindungsgemäße elektrische Vorrichtung, insbesondere zur Ansteuerung einer motorisch und/oder generatorisch betreibbaren elektrischen Maschine, umfassst zumindest ein Schaltmittelmodul, welches vorzugsweise zum Wechselrichten und/oder Gleichrichten elektrischer Spannungen vorgesehen ist, und wobei das Schaltmittelmodul durch eine Kühlvorrichtung kühlbar ist und auf dieser zumindest mittelbar aufliegt, ferner umfassend ein Fixierungsmittel und zumindest einen Leiter, welche mit dem Schaltmittelmodul und der Kühlvorrichtung übereinander angeordnet sind. In vorteilhafter Weise kann dadurch der Flächenverbrauch in einer Ebene deutlich geringer ausfallen kann und somit der Platzbedarf ganz besonders in einem Kraftfahrzeug, in dem ohnehin verhältnismäßig wenig Bauraum vorhanden ist, besser ausgenutzt werden kann.

Wird der zumindest eine Leiter durch ein Befestigungsmittel am Fixierungsmittel befestigt, so kann bereits vor einer Endmontage ein Modul aus Fixierungsmittel und Leiter vorgefertigt werden und somit zeitsparend endmontiert werden. Dies umsomehr, je mehr Leiter am Fixierungsmittel zu befestigen sind.

Erfindungsgemäß wird der zumindest eine Leiter durch zumindest eine isolierende Zwischenlage vom Fixierungsmittel elektrisch getrennt. Dadurch ist es möglich, das Fixierungsmittel ohne Rücksicht auf die Potenziallage des Leiters beispielsweise mit der elektrischen Masse zu verbinden.

Durch die in den Unteransprüchen aufgeführten Maßnahmen sind vorteilhafte Weiterbildungen der elektrischen Vorrichtung nach dem Hauptanspruch möglich.

Sind isolierende Zwischenlagen zwischen den einzelnen Leitern zumindest abschnittsweise derart gestaltet, dass diese über die Leiter überstehen, so ist es möglich, über diese Zwischenlagen einen sogenannten Kriechstromabstand stark zu vergrößern. Kurzschlüsse oder leistungsmindernde Kriechströme werden dadurch vermieden.

Eine gute Relativlagezuordnung zwischen isolierender Zwischenlage und/oder eines Leiters zum Fixierungsmittel ergibt sich dann, wenn die Lage durch ein Zentriermittel bestimmt ist.

Es ist vorteilhafterweise vorgesehen, dass das Fixiermittel aus dem gleichen Material wie das Gehäuse bzw. die Kühlvorrichtung der elektrischen Vorrichtung hergestellt ist. Dies führt dazu, dass Wärmespannungen zwischen einem Verbund aus Fixierungsmittel, Leiter, Schaltmittelmodul und Kühlvorrichtung weitgehend vermieden werden, da sich das Fixiermittel und auch das Material des Gehäuses mit dem gleichen Wärmeausdehnungskoeffizienten ausdehnen.

Um Kantenpressungen und sonstige unzulässig hohe Pressungen zwischen dem Fixiermittel und dem Schaltmittelmodul zu vermeiden ist vorgesehen, zwischen dem Fixiermittel und dem Schaltmittelmodul ein elastisches Modul vorzusehen.

Das Schaltmittelmodul weist sowohl Leiter auf, die hohe Ströme leiten, als auch Leiter, die niedrige Ströme leiten. Diese Hochstromleiter erwärmen sich stärker als die anderen so genannten Signalleiter. Es ist daher vorgesehen, die Hochstromleiter von den Signalleitern räumlich zu trennen und somit vorzusehen, dass aus einer Seite Leistungsleiter (Hochstromleiter) und aus einer Seite Signalleiter herausragen. Ein geeigneter Aufbau ergibt sich, wenn die Seiten einander gegenüber liegen.
Des Weiteren ist vorgesehen, dass die Leistungsleiter mit ihren Enden von der Kühlrichtung weg weisen. Dies hat den Vorteil, dass eine Verbindungsstelle zwischen den Leitern auf dem Schaltmittelmodul und den Leistungsleitern besonders günstig zugänglich ist. Desweiteren ist vorgesehen, dass die Signalleiter mit ihren Enden von der Kühlvorrichtung weg weisen. Dadurch ist es beispielsweise möglich, noch über der bereits erwähnten Anordnung aus Schaltmittelmodul, Fixierungsmittel, Leiter und Kühlvorrichtung eine Leiterplatte anzubringen. Diese Leiterplatte kann dann durch einfaches Aufsetzen in Richtung der eben erwähnten Bauteile mit den Signalleitern gefügt werden.

Nach einer weiteren Ausgestaltung der Erfindung ist vorgesehen, dass zu einer Gruppe der Signalleiter, die aus einer Seite des Schaltmittelmoduls herausragen, ein Leiter gehört, der eine Spannungsversorgung der Bereiche einer Leiterplatte ermöglicht, die für die Ansteuerung der Signalleiter erforderlich ist.

Nach einer weiteren Ausgestaltung der Erfindung ist vorgesehen, dass ein Abschirmmittel den zumindest einen Leiter überdeckt und so eine beispielsweise darüber angeordnete Leiterplatte von elektromagnetischen Einflüssen abgeschirmt ist. Es ist dabei vorgesehen, dass das Abschirmmittel zwischen dem zumindest einen Leiter und einem Schaltungsträger angeordnet ist.

Gemäß einer weiteren Ausgestaltung der Erfindung ist vorgesehen, dass eine Relativlage des Schaltmittelmoduls zur Kühlvorrichtung mittels Formschlusselementen definiert ist.

### Zeichnungen

In den Zeichnungen sind Ausführungsbeispiele der erfindungsgemäßen elektrischen Vorrichtung dargestellt.

Es zeigen:
Figur 1 einen Teilschnitt durch ein erstes Ausführungsbeispiel,
Figur 2 einen zweiten Querschnitt durch das erste Ausführungsbeispiel aus Figur 1 gemäß der Linie A-A,
Figur 3 einen Querschnitt eines zweiten Ausführungsbeispiels,
Figur 4 einen Querschnitt durch das zweite Ausführungsbeispiel gemäß der Linie B-B,
Figur 5 eine Prinzipdarstellung eines Systems aus Stromversorgung, erfindungsgemäßer elektrischer Vorrichtung und elektrischer Maschine.

### Beschreibung

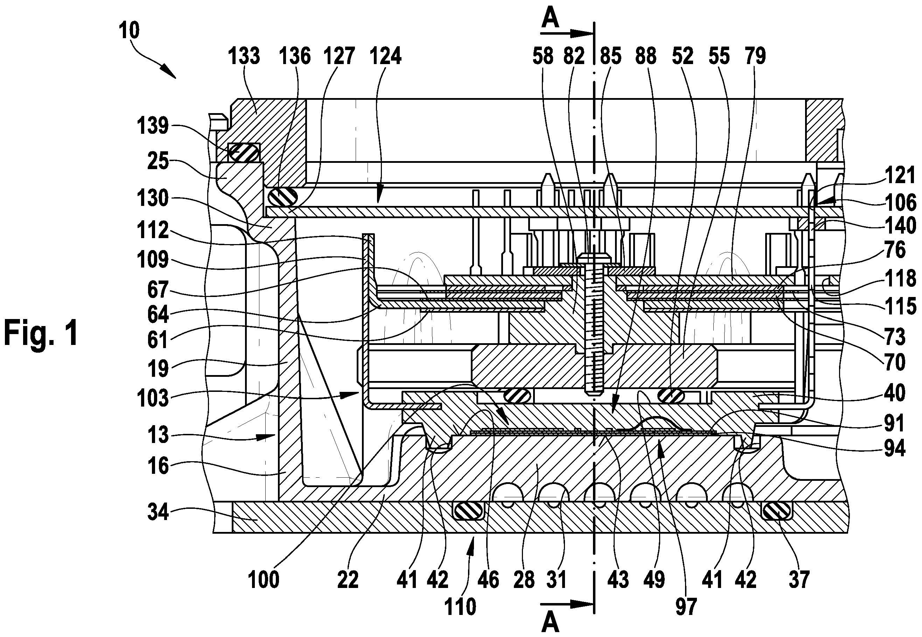

Figur 1 zeigt einen Teilquerschnitt durch eine elektrische Vorrichtung 10, die hier zur Ansteuerung einer nicht dargestellten, motorisch und/oder generatorisch betreibbaren elektrischen Maschine dient. Diese elektrische Vorrichtung 10 besteht aus einem Gehäuse 13, das aus mehreren Bauteilen zusammengesetzt ist. Das Gehäuse 13 besteht aus einem topfförmigen Gehäuseteil 16, in dem verschiedene elektrische und elektronische Bauteile angeordnet sind, auf die später noch eingegangen werden wird. Das topfförmige Gehäuseteil 16 weist eine Gehäusewand 19 auf, die in einem von einem Gehäuseboden 22 abgewandten Gehäuserand 25 endet. Der Gehäuseboden 22 hat einen in seiner Materialstärke etwas stärker ausgeführten Gehäuseabschnitt, der hier als Podest 28 bezeichnet ist. Dieses Podest 28 weist auf seiner vom Boden des Gehäuses 13 abgewandten Seite mehrere Kühlkanäle 31 auf, die durch einen Verschlussdeckel 34 geschlossen sind. Die Kühlkanäle 31 sind insgesamt durch eine Dichtung 37 flüssigkeitsdicht geschlossen. Auf diesem Podest 28 und in dem Gehäuse 13 sitzt zunächst ein Schaltmittelmodul 40 auf.

Die Relativlage zwischen Schaltmittelmodul 40 und Podest 28 bzw. Gehäuseboden 22 wird hier in diesem Ausführungsbeispiel mittels Formschlusselementen hergestellt. In diesem Ausführungsbeispiel ragen am Schaltmittelmodul 40 befestigte Zapfen 41 in Löcher 42 im Gehäuseboden 22 bzw. Podest 28 hinein.

Dabei liegt eine flache Oberfläche 43 des Schaltmittelmoduls 40 auf einer ebenso flachen Oberfläche 46 des Podestes 28 auf. In einer Vertiefung 49 des Schaltmittelmoduls 40 ist ein elastisches Element 52 eingelegt, das beispielsweise als Elastomer bzw. als Gummirundschnur o. ä. ausgebildet sein kann. Das Schaltmittelmodul 40 und das elastische Element 52 sind zwischen dem Podest 28 bzw. dem Gehäuseboden 22 und einem Fixierungsmittel 55 angeordnet bzw. verspannt, wie in der Beschreibung noch näher zu erläutert sein wird. Das Fixierungsmittel 55 ist hier im Wesentlichen balkenförmig ausgebildet und erstreckt sich der Länge nach über das ebenso länglich ausgebildete Podest 28. Das Fixierungsmittel 55 hat dabei die Aufgabe, das Schaltmittelmodul 40 auf das Podest 28 anzupressen und so den Wärmeübergang zwischen Podest 28 und Schaltmittelmodul 40 zu verbessern.

Auf dem Fixierungsmittel 55 sitzt ein Isolator 58. Auf diesem ringförmigen Isolator 58, der in der von dem Schaltmittelmodul 40 wegweisenden Richtung pyramidenartig gestuft ist, trägt auf einer ersten Stufe eine isolierende Zwischenlage 61, auf der ein Leiter 64 gelagert ist. Auf diesem Leiter 64 liegt wiederum und auch auf der vom Schaltmittelmodul 40 abgewandten Seite eine weitere isolierende Zwischenlage 67 auf, auf der wiederum ein weiterer Leiter 70 aufliegt. Auf diesem Leiter 70 wiederum liegt eine weitere isolierende Zwischenlage 73 und auf der isolierenden Zwischenlage 73 liegt ein weiterer Leiter 76 auf. Auf dem Leiter 76 liegt ein Abschirmmittel 79 auf. Der Isolator 58 wirkt somit als Zentriermittel und bestimmt die Lage der Leiter und Zwischenlagen.

Die einzelnen Leiter 64, 70 und 76 sowie die isolierenden Zwischenlagen 61, 67 und 73 bzw. Zwischenschichten sowie das Abschirmmittel 79 und der Isolator 58 werden durch ein Befestigungsmittel 82, das hier als Schraube ausgebildet ist mittels einer Unterlegscheibe 85 auf dem Fixierungsmittel 55 aufgepresst.

Das Schaltmittelmodul 40 ist im Wesentlichen tafelartig bzw. quaderförmig ausgebildet und weist im seinem Inneren eine elektronische Schaltung 88 auf. Diese elektronische Schaltung 88 sitzt beispielsweise auf einer keramischen Trägerplatte 91 auf, die wiederum auf ihrer Rückseite eine Wärmeleitplatte 94 aufweist. Diese Wärmeleitplatte 94 ist beispielsweise eine Platte aus Kupfer, die gegen das Podest 28 gelagert ist. Zur Verbesserung des Wärmeübergangs zwischen Wärmeleitplatte 94 und Podest 28 kann beispielsweise zwischen dem Schaltmittelmodul 40 und dem Podest 28 zusätzlich noch eine Wärmeleitpaste 97 vorgesehen sein. Auf der keramischen Trägerplatte 91 sind zumindest zwei schaltbare Halbbrücken 100 angeordnet, die hier in Figur 1 nur symbolisch dargestellt sind. Diese Halbbrücken 100 dienen dazu, einen bereitgestellten Gleichstrom derartig zu verändern, dass in einem Leistungsleiter 103 ein Wechselstrom bzw. Drehstrom erzeugt wird. Die Halbbrücken 100 werden dabei von mit diesen elektrisch verbundenen Signalleitern 106 gesteuert. Der Leistungsleiter 103 ist dabei zunächst an der Übergangsstelle vom Schaltmittelmodul 40 an dessen Außenseite parallel zur Oberfläche 46 des Podests 28 orientiert, um dann nach einigen Millimetern außerhalb des Schaltmittelmoduls 40 seine Richtung zu ändern, so dass ein Ende 109 des Leistungsleiters 103 von der Kühlvorrichtung bzw. dem Gehäuseboden 22 weg weist. Am Ende 109 überlappt dieses mit einem ebenso abgewinkelten Ende 112 des Leiters 64 und bildet hier eine Verbindungsstelle zu diesem Leiter 64, der einen Phasenanschluss für die elektrische Maschine darstellt. Aus einer anderen Seite des Schaltmittelmoduls 40 ragen die bereits erwähnten Signalleiter 106 heraus, die sich ebenso wie die Leistungsleiter bzw. der Leistungsleiter 103 zunächst geradlinig und parallel zur Oberfläche 46 des Podestes 28 erstrecken, um sich dann nach einer Biegung vom Gehäuseboden 22 weg weisend zu entfernen. Der Signalleiter 106 weist somit zwei Schenkel auf, wobei der erste Schenkel aus dem Schaltmittel 40 herausragt und der zweite Schenkel nach einem Knick vom Gehäuseboden 22 weg weist. Dieser zweite Schenkel 115 erstreckt sich durch eine Öffnung 118 des Abschirmmittels 79 hindurch, um letztlich durch Verbindungsöffnungen 121 eines Schaltungsträgers 124 bzw. einer Leiterplatte 124 hindurchzuragen. An diesen Verbindungsöffnungen 121 ist schließlich eine elektrische Verbindung zwischen den Signalleitern 106 und einer auf dem Schaltungsträger 124 angeordneten und hier nicht dargestellten elektrischen Schaltung verwirklicht.

Der Schaltungsträger 124 ist mit einem äußeren Rand 127 auf einem Absatz 130 der Gehäusewand 19 gelagert. Zwischen dem Rand 127 und einem Gehäusedeckel 133 ist ein elastisches Element 136 angeordnet. Eine weitere Dichtung 139 dichtet den Innenraum des Gehäuses 13 gegen die äußere Umgebung ab.

In Figur 1 ist somit eine elektrische Vorrichtung 10 dargestellt, die insbesondere zur Ansteuerung einer motorisch und/oder generatorisch betreibbaren elektrischen Maschine dient. Diese elektrische Vorrichtung 10 weist zumindest ein Schaltmittelmodul 40 auf, das vorzugsweise zum Wechselrichten und/oder Gleichrichten elektrischer Spannungen dient. Das Schaltmittelmodul 40 ist hierbei durch eine Kühlvorrichtung 110 kühlbar. Das Schaltmittelmodul 40 liegt hierbei auf dieser Kühlvorrichtung 110 zumindest mittelbar auf. Zumindest mittelbar aufliegen bedeutet hier, dass das Schaltmittelmodul 40 beispielsweise unter Zwischenschichtung einer Wärmeleitpaste 97 auf dem Podest 28 bzw. dem Gehäuseboden 22 aufliegt. Eine unmittelbare Auflage wäre beispielsweise durch Weglassen einer Wärmeleitplaste 97 gegeben. Ein Fixierungsmittel 55, zumindest ein Leiter 64 sowie das Schaltmittelmodul 40 und die Kühlvorrichtung 110 sind übereinander angeordnet. Es ist dabei vorgesehen, dass der zumindest eine Leiter 64 durch ein Befestigungsmittel 82 am Fixierungsmittel 55 befestigt ist. Im motorischen Betrieb dient der zumindest eine Leiter 64 zur Stromversorgung eines Phasenanschlusses einer elektrischen Maschine. Im generatorischen Betrieb wird vom Phasenanschluss bzw. Leiter 64 durch Betätigung der elektrischen Schaltung 88 ein (pulsierender) Gleichstrom erzeugt, mit dem durch hier nicht dargestellte Leitungen an eine (Hochstrom-) Batterie bzw. -akkumulator Strom geliefert wird. Der zumindest eine Leiter 64 - oder auch die anderen Leiter 70 und 76 sind durch zumindest eine isolierende Zwischenlage 61 bzw. 67 und 73 vom Fixierungsmittel 55 elektrisch getrennt. Wie somit bereits angedeutet, liegen auf dem zumindest einen Leiter 64 weitere Leiter 70 bzw. 76 auf, die voneinander durch isolierende Zwischenlagen 67 und 73 elektrisch getrennt sind.

Wie in Figur 1 auch zu erkennen ist, ragen die isolierenden Zwischenlagen 61, 67 und 73 etwas und hier zumindest abschnittsweise über die Leiter 70 und 76 hinaus.

Durch das Befestigungsmittel 82 wirkt zwischen dem zumindest einen Leiter 64 und dem Fixierungsmittel 55 eine Anpresskraft. Das Fixiermittel 55 soll aus dem gleichen Material wie das Gehäuse 13 bzw. der Gehäuseboden 22 sein, der die Kühlvorrichtung 110 aufweist und eine Unterlage des Schaltmittelmoduls 40 darstellt. Es ist vorgesehen, dass zwischen dem Fixiermittel 55 und dem Schaltmittelmodul 40 das elastische Element 52 angeordnet ist. Das elastische Element 52 ist aus einem elastischen Kunststoff, vorzugsweise einem Elastomer, gefertigt.

Wie in Figur 1 dargestellt, ist vorgesehen, dass aus dem Schaltmittelmodul 40 aus mehreren Seiten Leiter herausragen. Dabei ist vorgesehen, dass aus einer Seite Leistungsleiter 103 und aus einer anderen Seite des Schaltmittelmoduls 40 Signalleiter 106 herausragen. Die Leistungsleiter 103 und die Signalleiter 106 weisen mit ihren Enden 109 bzw. 140 von der Kühlvorrichtung 110 weg. Alternativ könnte auch beispielsweise der Leiter 64 mit seinem in Figur 1 oberen Ende nach unten abgewinkelt sein und sich im Niveau zwischen dem Schaltmittelmodul 40 und dem Gehäuseboden 22 treffen und dort letztlich miteinander verschaltet sein. In diesem Fall würde der Leistungsleiter 103 nicht mit seinem Ende 109 von der Kühlvorrichtung 110 weg weisen.

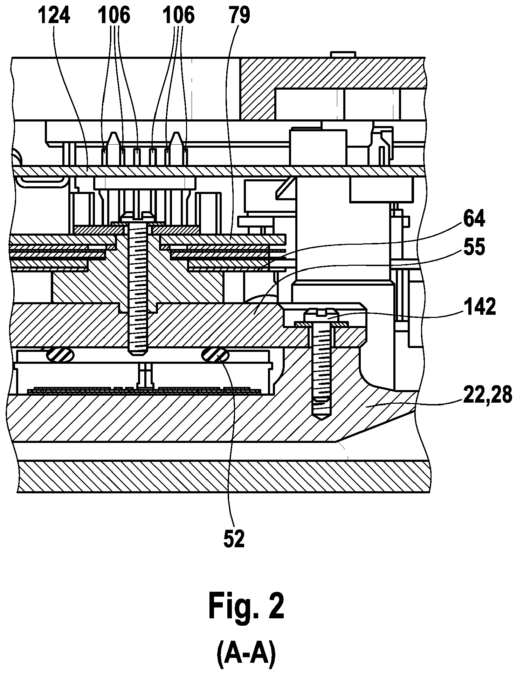

Figur 2 zeigt wie bereits erwähnt eine Ansicht quer zur Ansicht gemäß Figur 1. Während in Figur 1 nur ein Signalleiter 106 in einer Seitenansicht erkennbar ist, so sind in der Figur 2 sechs Signalleiter 106 erkennbar, wobei zu dieser Gruppe der Signalleiter 106 ein Leiter gehört, der eine Spannungsversorgung des Schaltungsträgers 124 ermöglicht. Das Abschirmmittel 79 überdeckt den zumindest einen Leiter 64, wobei dies nicht bedeutet, dass das Abschirmmittel 79 diesen Leiter vollständig überdeckt, sondern das Abschirmmittel 79 zumindest einen Leiter 64, 70, 76 zumindest teilweise überdeckt. Wie in Figur 1 und Figur 2 erkennbar ist, ist das Abschirmmittel 79 zwischen dem zumindest einen Leiter 64 und dem Schaltungsträger 124 angeordnet. Wie in Figur 2 erkennbar ist, ist das Fixierungsmittel 55 durch ein Befestigungsmittel 142 in Form einer Schraube mit dem Gehäuseboden 22 bzw. dem Podest 28 fest verbunden. Das Fixierungsmittel 55 presst hier mittels des elastischen Elements 52 auf das Schaltmittelmodul 40.

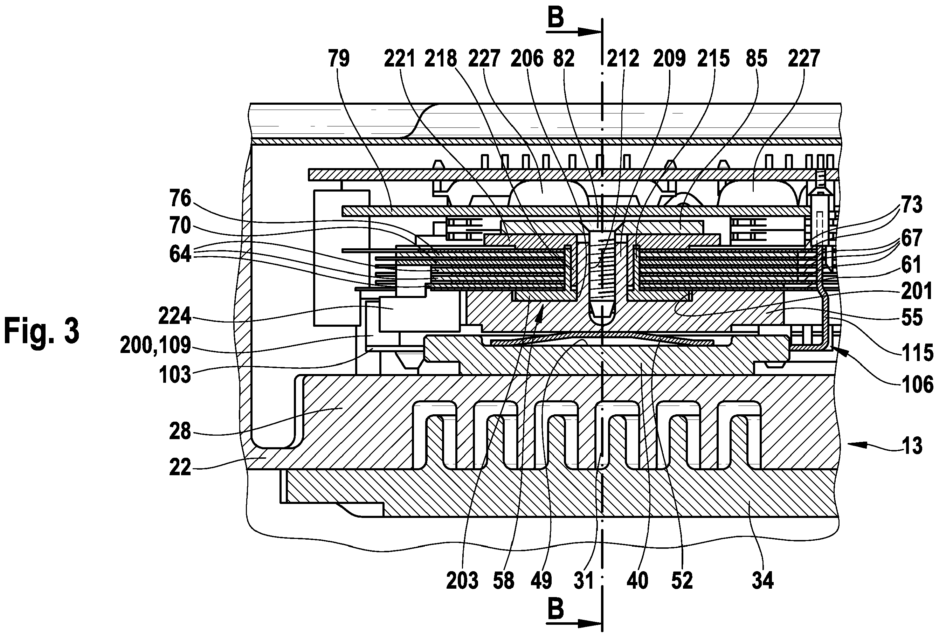

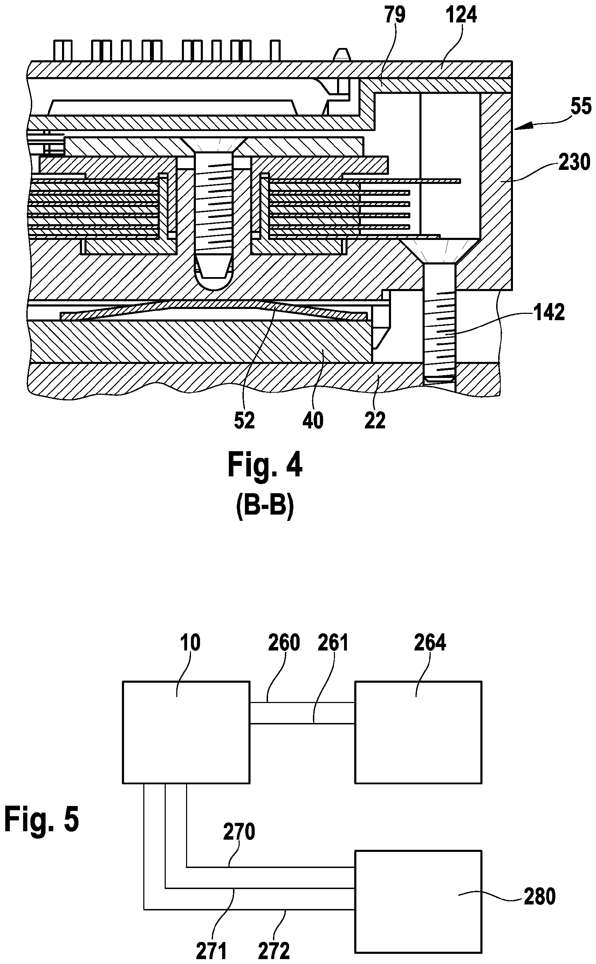

In Figur 3 und Figur 4 ist ein zweites Ausführungsbeispiel dargestellt. Bei der Beschreibung der Figur 3 wird nunmehr auf die wesentlichen Unterschiede zu Figur 1 bzw. Figur 2 eingegangen. Es sei hier vermerkt, dass gleiche Bezugszeichen Gegenstände gleicher Funktion, wie beim ersten Ausführungsbeispiel, bezeichnen. Das Schaltmittelmodul 40 liegt wiederum auf einem Podest 28 auf. Auf der rechten Seite des Schaltmittelmoduls 40 treten Signalleiter 106 mit ihren zweiten Schenkeln 115 heraus, die letztlich den Schaltungsträger 124 kontaktieren. Die Leistungsleiter 103 sind wiederum blechartig, wobei das Ende 109 in diesem Fall ein abgewinkelter Blechlappen 200 ist.

In der Vertiefung 49 des Schaltmittelmoduls 40 sitzt zwar wieder ein elastisches Element 52 als Kraftübertragungselement zwischen Fixierungsmittel 55 und Schaltmittelmodul 40, dieses elastische Element 52 ist nunmehr jedoch durch eine metallische Andruckfeder dargestellt, die beispielsweise wie eine Blattfeder wirkt bzw. ist. Das Fixierungsmittel 55 weist wiederum eine Vertiefung 201 auf, in der der Isolator 58 sitzt. Der Isolator 58 weist eine kreisringförmige Platte 203 auf, die in ihrer Mitte eine zentrale Öffnung 206 hat. Diese zentrale Öffnung 206 umgreift einen ringzylindrischen Zapfen 209, der einstückig aus dem Fixierungsmittel 55 herausgebildet ist. Der Zapfen 209 weist somit eine bohrungsartige Öffnung 212 auf, die mit einem Innengewinde versehen ist, sodass das Befestigungsmittel 82 in Form einer Schraube darin eingreifen kann. Von der Platte 203 geht ein kreisringförmiger Stutzen 215 aus, der den Zapfen 209 umgibt. Zwischen dem Zapfen 209 und dem Stutzen 215 greift ein weiterer Stutzen 218 ein, der von einer Platte 221 ausgeht. Beide Stutzen 215 und 218 sind vor der Montage gegeneinander gerichtet. Zwischen den beiden Platten 203 und 221 sind mehrere Leiter 64 angeordnet, die jeweils unterschiedlichen Phasen der elektrischen Maschine, die hier nicht dargestellt ist, zugeordnet werden. Im Beispiel wären dies drei Leiter 64 für drei verschiedene Phasen einer dreiphasigen Maschine. Wäre diese Maschine beispielsweise fünfphasig oder gar sechsphasig, wären an dieser Stelle fünf bzw. sechs Leiter 64 angeordnet. Auch diesen Leitern 64 sind des Weiteren ein Leiter 70 und ein Leiter 76 angeordnet, die jeweils die Aufgabe haben, das Schaltmittelmodul 40 entweder mit Gleichspannung zu versorgen, oder vom Schaltmittelmodul 40 erzeugte (pulsierende) Gleichspannung an eine hier ebenfalls nicht dargestellte Batterie bzw. an einen Akkumulator zu senden. In gewohnter Weise sind zwischen den Leitern 64, 70 und 76 isolierende Zwischenlagen 61, 67 und 73 angeordnet, so dass Kurzschlüsse vermieden werden. Von einem Leiter 64 gehen hier ebenfalls abgewinkelte Blechlappen 224 aus, die in direkter benachbarter Lage zu den Blechlappen 200 stehen. Die Blechlappen 200 bzw. 224 sind elektrisch miteinander bleibend verbunden und stellen die elektrische Verbindung zu dem Schaltmittelmodul 40 und Phasenanschluss der elektrischen Maschine dar. Auch hier überdeckt das Abschirmmittel 79 den zumindest einen Leiter 64 bzw. die Leiter 64. Auch hier ist darunter nicht das vollständige Abdecken zwangsläufig zu verstehen. Das Abschirmmittel 79 weist in diesem Beispiel mehrere Auswölbungen 227 auf, die als Auflager für den Schaltungsträger 124 dienen und an denen diese angeschraubt ist. Der Schaltungsträger 124 ist in vertikaler Richtung von dem Stapelaufbau entkoppelt. Die Signalleiter 106 besitzen eine federelastische Eigenschaft, um die Toleranzen und unterschiedlichen Wärmeausdehnungen zu kompensieren.

Die Zentralreferenz bei diesem Aufbau übernimmt der Kühlkörper.

In Figur 4 ist eine Schnittdarstellung durch das Schaltmittelmodul 40 auf Figur 3 dargestellt, wobei diese Darstellung nunmehr quer (90°) zu der Darstellung in Figur 3 angeordnet ist. Wie bereits beim Ausführungsbeispiel nach Figur 1 und Figur 2 ist auch hier das Fixierungsmittel 55 mittels eines Befestigungselements 142 am Gehäuseboden 22 befestigt. Das elastische Element 52 in Form der bereits erwähnten Blattfeder ist hier gut zu erkennen. Das Fixierungsmittel 55 weist hier einen über das Schaltmittelmodul 40 hinaus kragenden Rand 230 auf, auf dem das Abschirmmittel 79 mit einem Rand aufliegt. Auf dem Abschirmmittel 79 kommt darüber hinaus der Schaltungsträger 124 zu liegen. Wie bereits beim vorherigen Ausführungsbeispiel ragen die isolierenden Zwischenlagen 61, 67 bzw. 73 über die Leiter 64 bzw. 70 und 76 hinaus.

In Figur 5 ist schematisch die elektrische Vorrichtung 10 dargestellt, die mit zwei Leitern 260 und 261 mit einem elektrischen Energiespeicher wie einer Batterie bzw. einem Akkumulator 264 verbunden sind. Die Vorrichtung 10 ist mittels dreier Phasenleiter 270, 271 und 272 mit der elektrischen Maschine 280 verbunden. Wäre die elektrische Maschine 280 eine nicht dreiphasige sondern beispielsweise einer vier- oder fünfphasige Maschine, würden vier oder fünf Phasenanschlüsse eine Verbindung zwischen der Vorrichtung 10 und der elektrischen Maschine 280 darstellen.

Die Formschlusselemente können selbstverständlich auch umgekehrt angeordnet sein, sodass die Zapfen 41 am Podest 28 bzw. dem Gehäuseboden 22 angeordnet sind, während die Löcher 42 am Schaltmittelmodul 40 angeordnet sind. Das Übereinanderschichten der Leiter 64 bzw. 70 und 76 im ersten Ausführungsbeispiel bzw. der Leiter 64 bzw. 70 und 76 beim zweiten Ausführungsbeispiel wird gelegentlich auch als so genannte "BUS-BAR- Technologie" bezeichnet. Die Leiter 64 werden auch als Phasenblech bezeichnet, da diese blechartig ausgebildet sind und den elektrischen Phasen der elektrischen Maschine 280 zugeordnet sind. Die Leiter 70 bzw. 76 werden auch als so genanntes Traktionsblech bezeichnet, da diese blechartig und die Leiter sind, die den Antriebsstrom von der Batterie 264 an die elektrische Maschine 280 übermitteln. Das Abschirmmittel 79 ist beispielsweise als ein Blech ausgeführt, das die EMV-Abschirmung darstellt und gleichzeitig als Träger für die Leiterplatte bzw. den Schaltungsträger 124 dient. Im Ausführungsbeispiel gemäß Figur 1 und Figur 2 wird der Schaltungsträger 124 auf das Abschirmmittel 79 geschraubt. Hier sind jedoch auch andere Fixierungsmöglichkeiten wie z. B. Klemmen oder Kleben denkbar.

Gemäß einem weiteren hier nicht näher gezeichneten und dargestellten Ausführungsbeispiel könnte das Schaltmittelmodul 40 auch direkt auf den Kühlkörper bzw. das Podest 28 bzw. dem Gehäuseboden 22 ausgeschraubt und somit auch positioniert sein. Als Positionierung könnten hier entsprechende Merkmale des Schaltmittelmoduls 40 dienen, so z. B. Zentrierzapfen. Die Zentrierung könnte auch über eine Schraubung oder ähnliche Befestigungsmittel erfolgen. Das Fixierungsmittel 55 könnte dann über die Schaltmittelmodule 40 oder über den Gehäuseboden 22 bzw. das Podest 28 zentriert werden. Das elastische Federelement 52 wäre dann nicht mehr notwendig.

Während in den vorgenannten drei Ausführungsbeispielen das Fixierungselement 55 immer zwischen dem Schaltmittelmodul 40 und der "BUS-BAR", d. h. den Leitern 64 bzw. 70 und 76 angeordnet ist, könnte das Fixierungsmittel 55 auch oberhalb der vorgenannten Leiter angeordnet sein, sodass die Leiter 64, 70 und 76 zwischen dem Fixierungsmittel 55 und dem Schaltmittelmodul 40 angeordnet wären. Das elastische Element 52 könnte hier beispielsweise aus einer Federstahlplatte ausgebildet sein, welches die unterste Lage der BUS-BAR bilden würde. Beim Fixieren der BUS-BAR auf den Gehäuseboden 22 bzw. dem Podest 28 würde das Schaltmittelmodul 40 auf das Podest 28 bzw. den Gehäuseboden 22 gedrückt werden. Würde das Schaltmittelmodul 40 auf den Kühlkörper bzw. den Gehäuseboden 22 bzw. das Podest 28 geschraubt bzw. mit ähnlich wirkendem Mittel befestigt, wäre das Andrücken nicht mehr erforderlich und das Federelement bzw. elastische Element 52 könnte wie auch im Ausführungsbeispiel 3 entfallen.

## Patentansprüche

1. Elektrische Vorrichtung, insbesondere zur Ansteuerung einer motorisch und/oder generatorisch betreibbaren elektrischen Maschine (280), mit zumindest einem Schaltmittelmodul (40), vorzugsweise zum Wechselrichten und/oder Gleichrichten elektrischer Ströme, wobei das Schaltmittelmodul (40) durch eine Kühlvorrichtung (110) kühlbar ist und auf dieser zumindest mittelbar aufliegt, und mit einem Montagemodul, welches aus einem Fixierungsmittel (55) zur Anpressung des Schaltmittelmoduls (40) auf die Kühlvorrichtung (110) und zumindest einem am Fixierungsmittel (55) befestigten Leiter (64) besteht, wobei der zumindest eine Leiter (64) zur Stromversorgung eines Phasenanschlusses der elektrischen Maschine (280) dient, und wobei das Montagemodul, das Schaltmittelmodul (40) und die Kühlvorrichtung (110) übereinander angeordnet sind, **dadurch gekennzeichnet, dass** der zumindest eine Leiter (64) durch zumindest eine isolierende Zwischenlage (58, 61,63,73) vom Fixierungsmittel (55) elektrisch getrennt ist und dass das Fixierungsmittel (55) mit der elektrischen Masse verbindbar ist.

2. Elektrische Vorrichtung nach Anspruch 1, **dadurch gekennzeichnet, dass** der zumindest eine Leiter (64) durch ein Befestigungsmittel (82) am Fixierungsmittel (55) befestigt ist.

3. Elektrische Vorrichtung nach Anspruch 1 oder 2, **dadurch gekennzeichnet, dass** auf dem zumindest einen Leiter (64) weitere Leiter (64, 70, 76) aufliegen, die voneinander durch isolierende Zwischenlagen (61, 67, 73) bzw. Zwischenschichten elektrisch getrennt sind.

4. Elektrische Vorrichtung nach Anspruch 3, **dadurch gekennzeichnet, dass** die isolierenden Zwischenlagen (61, 67, 73) bzw. Zwischenschichten zumindest abschnittweise über die Leiter (64, 70, 76) überstehen.

5. Elektrische Vorrichtung nach einem der Ansprüche 3 oder 4, **dadurch gekennzeichnet, dass** eine Lage zumindest einer isolierender Zwischenlage (61, 67, 73) und/oder zumindest eines Leiters (64, 70, 76) zum Fixierungsmittel (55) durch ein Zentriermittel (58) bestimmt ist.

6. Elektrische Vorrichtung nach Anspruch 5, **dadurch gekennzeichnet, dass** das Zentrierelement (58) ein Isolator ist.

7. Elektrische Vorrichtung nach einem der vorstehenden Ansprüche, **dadurch gekennzeichnet, dass** das Fixierungsmittel (55) aus dem gleichen Material wie eine Unterlage des Schaltmittelmoduls (40) ist.

8. Elektrische Vorrichtung nach einem der vorstehenden Ansprüche, **dadurch gekennzeichnet, dass** zwischen dem Fixierungsmittel (55) und dem Schaltmittelmodul (40) ein elastisches Element (52) angeordnet ist.

9. Elektrische Vorrichtung nach einem der vorstehenden Ansprüche, **dadurch gekennzeichnet, dass** aus mehreren Seiten des Schaltmittelmoduls (40) Leiter (64, 106) herausragen, wobei aus einer Seite Leistungsleiter (103) und aus einer anderen Seite Signalleiter (106) herausragen.

10. Elektrische Vorrichtung nach Anspruch 9, **dadurch gekennzeichnet, dass** die Leistungsleiter (103) und/oder die Signalleiter (106) mit ihren Enden (109, 115) von der Kühlvorrichtung (110) weg weisen.

11. Elektrische Vorrichtung nach einem der Ansprüche 9 oder 10, **dadurch gekennzeichnet, dass** zu der Gruppe der Signalleiter (106) ein Leiter gehört, der eine Spannungsversorgung des Schaltungsträgers (124) ermöglicht.

12. Elektrische Vorrichtung nach einem der vorstehenden Ansprüche, **dadurch gekennzeichnet, dass** ein Abschirmmittel (79) zumindest einen Leiter (64, 70, 76) zumindest teilweise überdeckt.

13. Elektrische Vorrichtung nach Anspruch 12, **dadurch gekennzeichnet, dass** das Abschirmmittel (79) zwischen dem zumindest einem Leiter (64) und einem Schaltungsträger (124) angeordnet ist.

14. Elektrische Vorrichtung nach einem der vorstehenden Ansprüche, **dadurch gekennzeichnet, dass** eine Relativlage des Schaltmittelmoduls (40) zur Kühlvorrichtung (110) mittels Formschlusselementen (41, 42) definiert ist.

## Claims

1. Electrical apparatus, in particular for actuating an electrical machine (280) which can be operated as a motor and/or as a generator, comprising at least one switching means module (40), preferably for inverting and/or rectifying electric currents, wherein the switching means module (40) can be cooled by a cooling apparatus (110) and rests at least indirectly on the said cooling apparatus, and comprising a mounting module which consists of a fixing means (55) for pressing the switching means module (40) onto the cooling apparatus (110) and at least one conductor (64) which is fastened to the fixing means (55), wherein the at least one conductor (64) serves to supply current to a phase connection of the electrical machine (280), and wherein the mounting module, the switching means module (40) and the cooling apparatus (110) are arranged one above the other, **characterized in that** the at least one conductor (64) is electrically isolated from the fixing means (55) by at least one insulating intermediate layer (58, 61, 63, 73), and **in that** the fixing means (55) is connected to can be electrical earth.

2. Electrical apparatus according to Claim 1, **characterized in that** the at least one conductor (64) is fastened to the fixing means (55) by a fastening means (82).

3. Electrical apparatus according to Claim 1 or 2, **characterized in that** further conductors (64, 70, 76), which are electrically isolated from one another by insulating intermediate layers (61, 67, 73), rest on the at least one conductor (64).

4. Electrical apparatus according to Claim 3, **characterized in that** the insulating intermediate layers (61, 67, 73) protrude at least in sections beyond the conductors (64, 70, 76).

5. Electrical apparatus according to either of Claims 3 and 4, **characterized in that** a position of at least one insulating intermediate layer (61, 67, 73) and/or at least one conductor (64, 70, 76) in relation to the fixing means (55) is determined by a centring means (58).

6. Electrical apparatus according to Claim 5, **characterized in that** the centring element (58) is an insulator.

7. Electrical apparatus according to one of the preceding claims, **characterized in that** the fixing means (55) is composed of the same material as a substrate of the switching means module (40).

8. Electrical apparatus according to one of the preceding claims, **characterized in that** an elastic element (52) is arranged between the fixing means (55) and the switching means module (40).

9. Electrical apparatus according to one of the preceding claims, **characterized in that** conductors (64, 106) protrude out of several sides of the switching means module (40), wherein power conductors (103) protrude out of one side and signal conductors (106) protrude out of another side.

10. Electrical apparatus according to Claim 9, **characterized in that** the power conductors (103) and/or the signal conductors (106), by way of their ends (109, 115), point away from the cooling apparatus (110).

11. Electrical apparatus according to either of Claims 9 and 10, **characterized in that** a conductor which allows voltage to be supplied to the circuit carrier (124) belongs to the group of signal conductors (106).

12. Electrical apparatus according to one of the preceding claims, **characterized in that** a shielding means (79) at least partially overlaps at least one conductor (64, 70, 76).

13. Electrical apparatus according to Claim 12, **characterized in that** the shielding means (79) is arranged between the at least one conductor (64) and a circuit carrier (124).

14. Electrical apparatus according to one of the preceding claims, **characterized in that** a relative position of the switching means module (40) in relation to the cooling apparatus (110) is defined by means of interlocking elements (41, 42).

## Revendications

1. Dispositif électrique, notamment destiné à commander une machine électrique (280) pouvant fonctionner en régime de moteur et/ou en régime de générateur, comprenant au moins un module de moyens de commutation (40), de préférence pour onduler et/ou pour redresser des courants électriques, le module de moyens de commutation (40) pouvant être refroidi par un dispositif de refroidissement (110) et reposant au moins indirectement sur celui-ci, et comprenant un module de montage, lequel se compose d'un moyen de calage (55) servant à presser le module de moyens de commutation (40) contre le dispositif de refroidissement (110) et au moins un conducteur (64) fixé au moyen de calage (55), l'au moins un conducteur (64) servant à l'alimentation électrique d'une borne de phase de la machine électrique (280), et le module de montage, le module de moyens de commutation (40) et le dispositif de refroidissement (110) étant disposés les uns au-dessus des autres, **caractérisé en ce que** l'au moins un conducteur (64) est séparé électriquement du moyen de calage (55) par au moins une couche intermédiaire (58, 61, 63, 73) isolante et **en ce que** le moyen de calage (55) peut être relié à la masse électrique.

2. Dispositif électrique selon la revendication 1, **caractérisé en ce que** l'au moins un conducteur (64) est fixé au moyen de calage (55) par un moyen de fixation (82).

3. Dispositif électrique selon la revendication 1 ou 2, **caractérisé en ce que** des conducteurs supplémentaires (64, 70, 76) reposent sur l'au moins un conducteur (64), lesquels sont séparés électriquement les uns des autres par des couches intermédiaires (61, 67, 73) ou des strates intermédiaires isolantes.

4. Dispositif électrique selon la revendication 3, **caractérisé en ce que** les couches intermédiaires (61, 67, 73) ou les strates intermédiaires isolantes dépassent au moins dans certaines portions au-dessus des conducteurs (64, 70, 76).

5. Dispositif électrique selon l'une des revendications 3 ou 4, **caractérisé en ce qu'**une position d'au moins une couche intermédiaire (61, 67, 73) isolante et/ou d'au moins un conducteur (64, 70, 76) par rapport au moyen de calage (55) est déterminée par un moyen de centrage (58).

6. Dispositif électrique selon la revendication 5, **caractérisé en ce que** l'élément de centrage (58) est un isolateur.

7. Dispositif électrique selon l'une des revendications précédentes, **caractérisé en ce que** le moyen de calage (55) se compose du même matériau qu'un support du module de moyens de commutation (40).

8. Dispositif électrique selon l'une des revendications précédentes, **caractérisé en ce qu'**un élément élastique (52) est disposé entre le moyen de calage (55) et le module de moyens de commutation (40).

9. Dispositif électrique selon l'une des revendications précédentes, **caractérisé en ce que** des conducteurs (64, 106) font saillie de plusieurs côtés du module de moyens de commutation (40), des conducteurs de puissance (103) faisant saillie d'un côté et des conducteurs de signal (106) de l'autre côté.

10. Dispositif électrique selon la revendication 9, **caractérisé en ce que** les conducteurs de puissance (103) et/ou les conducteurs de signal (106) s'éloignent du dispositif de refroidissement (110) par leurs extrémités (109, 115).

11. Dispositif électrique selon l'une des revendications 9 ou 10, **caractérisé en ce que** le groupe des conducteurs de signal (106) comprend un conducteur qui permet une alimentation électrique du porte-circuit (124).

12. Dispositif électrique selon l'une des revendications précédentes, **caractérisé en ce qu'**un moyen de blindage (79) recouvre au moins partiellement au moins un conducteur (64, 70, 76).

13. Dispositif électrique selon la revendication 12, **caractérisé en ce que** le moyen de blindage (79) est disposé entre l'au moins un conducteur (64) et un porte-circuit (124).

14. Dispositif électrique selon l'une des revendications précédentes, **caractérisé en ce qu'**une position relative du module de moyens de commutation (40) par rapport au dispositif de refroidissement (110) est définie au moyen d'éléments à complémentarité de formes (41, 42).
